# EUROPEAN PATENT APPLICATION

(11) **EP 2 088 839 A1**
(43) Date of publication of application: **12.08.2009**
(21) Application number: 09001088.5
(22) Date of filing: 27.01.2009
(51) Int. Cl.: H05K 3/00, H01L 21/68

(54) **Method of forming an electronic device on a substrate supported by a carrier and resultant device**

(30) Priority: 08.02.2008 US 28182
(71) Applicant: Carestream Health, Inc., Rochester, NY 14608-1733 (US)
(72) Inventor: Kerr, Roger S., New York 14420 (US); Tredwell, Timothy John, New York 14450 (US); Harland, Mark A., Hilton, New York 14468 (US); Murray, James T., Holley, New York 14470 (US)
(74) Representative: Emde, Eric

(57) **Abstract**

A method for forming an electronic device on a flexible substrate conditions the surface of a carrier to form a holding area for retaining the flexible substrate. A contact surface of the flexible substrate is applied against the carrier with an intermediate binding material applied between at least the holding area of the carrier and the corresponding area of the contact surface. Entrapped gas between the flexible substrate and the carrier is removed and the substrate processed to form the electronic device thereon. The substrate can then be removed from the holding area to yield the resultant electronic device.

## Description

### FIELD OF THE INVENTION

This invention generally relates to electronic device fabrication and more particularly relates to a method for mounting a flexible substrate to a carrier and forming an electronic device on the substrate.

### BACKGROUND OF THE INVENTION

Thin-film transistor (TFT) devices are widely used in switching or driver circuitry for electro-optical arrays and display panels. TFT devices are conventionally fabricated on rigid substrates, typically glass or silicon, using a well-known sequence of deposition, patterning and etching steps. For example, amorphous silicon TFT devices require deposition, patterning, and etching of metals, such as aluminum, chromium or molybdenum; of amorphous silicon semiconductors; and of insulators, such as Si02 or Si3N4, onto a substrate. The semiconductor thin film is formed in layers having typical thicknesses ranging from several nm to several hundred nm, with intermediary layers having thicknesses on the order of a few microns, and may be formed over an insulating surface that lies atop the rigid substrate.

The requirement for a rigid substrate has been based largely on the demands of the fabrication process itself. Thermal characteristics are of particular importance, since TFT devices are fabricated at relatively high temperatures. Thus, the range of substrate materials that have been used successfully is somewhat limited, generally to glass, quartz, or other rigid, silicon-based materials.

TFT devices can be formed on some types of metal foil and plastic substrates, allowing some measure of flexibility in their fabrication. However, problems such as chemical incompatibility between the substrate and TFT materials, thermal expansion mismatch between substrate and device layers, planarity and surface morphology, and capacitive coupling or possible shorting make metal foil substrates more difficult to employ in many applications.

The fabrication process for the TFT may require temperatures in the range of 200-300 degrees C or higher, including temperatures at levels where many types of plastic substrates would be unusable. Thus, it is widely held, as is stated in U.S. Patent No. 7,045,442 (Maruyama et al.), that a TFT cannot be directly formed on a plastic substrate. In order to provide the benefits of TFT devices mounted on a plastic substrate, the Maruyama et al. '442 disclosure describes a method that forms the TFT on a release layer that is initially attached to a carrier substrate. Once the TFT circuitry is fabricated, the release layer is then separated from its carrier substrate and can be laminated onto a lighter and more flexible plastic material.

While there have been some solutions proposed for forming TFT components on flexible substrates, there are still a number of significant technical hurdles. Lamination of a release layer that is populated with TFT devices, as described in Maruyama et al. '442 requires additional fabrication steps and materials and presents inherent alignment difficulties. The use of higher-performance plastics still leaves difficulties with thermal expansion (expressed in terms of Coefficient of Thermal Expansion, CTE) and requires additional layers and processes in order to protect the plastic. Solutions using pulsed excimer lasers do not provide the full breadth of capabilities of more conventional TFT fabrication techniques and thus have limited utility. None of the known methods just discussed provides a flexible substrate that truly serves to replace glass or other silicon-based substrate, since the TFT must be formed either on a release layer or on some intermediate layer that must be formed on top of the flexible substrate.

TFT fabrication onto flexible substrates generally requires that the substrate be held on a carrier of some type during the various stages of layer deposition. One of the more important functions of such a carrier is providing dimensional stability to the flexible substrate. Thus, for example, a rigid glass carrier is conventionally provided. As described in Japanese Patent Publication Number JP 7-325297 A2 (Ichikawa), TFT devices can be formed onto a plastic substrate that is temporarily held to a glass carrier by means of an adhesive layer.

The use of a glass carrier, however, imposes some constraints on the types of flexible substrate materials that can be used. Some types of plastics are compatible with the use of a glass substrate, but can be impractical because they exhibit glass transition, Tg, temperatures near the region of temperatures used for deposition. Thus, plastic substrates can tend to soften somewhat, allowing unwanted expansion during a fabrication cycle. Metals do not have this disadvantage. However, metallic materials are not as dimensionally "forgiving" with change in temperature. A significant difference in coefficient of thermal expansion (CTE) between metals and glass results in excessive stress that can shatter glass or can cause a metal substrate to release from a glass carrier prematurely, losing its dimensional stability.

Thus, it can be seen that although there has been great interest in developing and expanding the use of both plastics and metals as flexible substrates, compatibility with a conventional glass carrier imposes some constraints on substrate material type.

### SUMMARY OF THE INVENTION

An object of the present invention is to provide a method for forming an electronic device comprising steps of conditioning the surface of a carrier to form a holding area for retaining a flexible substrate; applying a contact surface of the flexible substrate against the carrier with a binding intermediate material applied between at least the holding area of the carrier and the corresponding area of the contact surface; removing entrapped gas between the flexible substrate and the carrier; processing the substrate to form the electronic device thereon; and removing the flexible substrate from the holding area.

Another object of the present invention is to provide an electronic device fabricated onto a flexible substrate. The range of flexible substrates available using embodiments of the present invention can include various types of metal, including some types of metal foil, and other very thin substrates.

An advantage of the present invention is that it adapts a glass or other similar carrier for processing a flexible substrate at high temperatures.

These and other objects, features, and advantages of the present invention will become apparent to those skilled in the art upon a reading of the following detailed description when taken in conjunction with the drawings wherein there is shown and described an illustrative embodiment of the invention.

### BRIEF DESCRIPTION OF THE DRAWINGS

While the specification concludes with claims particularly pointing out and distinctly claiming the subject matter of the present invention, it is believed that the invention will be better understood from the following description when taken in conjunction with the accompanying drawings.
FIG. 1 is a side view of an electronic device formed on a flexible substrate supported on a carrier.
FIG. 2 is a perspective view of the conditioned surface of a substrate carrier in one embodiment.
FIG. 3 is a perspective view of a flexible substrate partially applied against the conditioned surface of the substrate carrier.
FIG. 4 is a perspective view of a flexible substrate fully applied against the conditioned surface of the substrate carrier with the conditioned area of the carrier centered with respect to the substrate.
FIG. 5 is a cutaway side view taken along line 5-5 of FIG. 4, showing a substrate mounting in one embodiment.

### DETAILED DESCRIPTION OF THE INVENTION

It is to be understood that elements not specifically shown or described in the following detailed description may take various forms well known to those skilled in the art. The figures given in this application are representative of overall spatial relationships and arrangement of layers for deposition onto a substrate and may not be drawn to scale.

As the term is used in the present description, "plastic" refers to a material having a high polymer content, usually made from polymeric synthetic resins, which may be combined with other ingredients, such as curing agents, fillers, reinforcing agents, colorants, and plasticizers. A "resin" is a synthetic or naturally occurring polymer. Plastic is solid in its finished state, and, at some stage during its manufacture or processing into finished articles, can be shaped by flow. Plastics are typically formed using a curing process in which a solvent is evaporated at a suitable rate. Plastic includes thermoplastic materials and thermosetting materials. The term "flexible" refers generally to sheet materials that are thinner than about 1.5 mm.

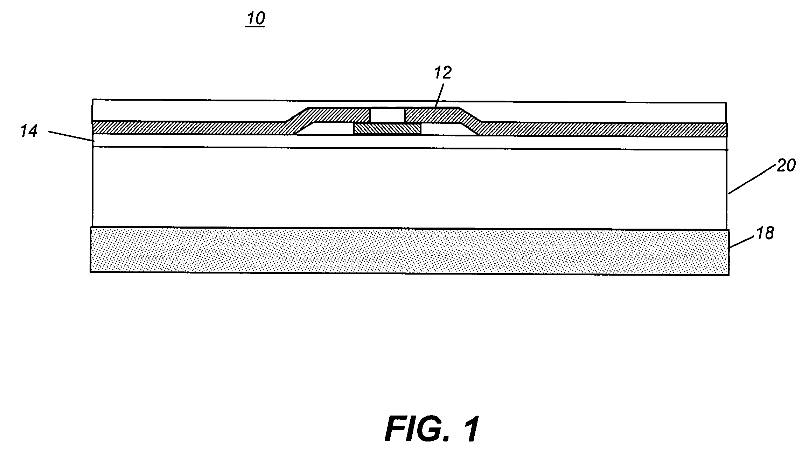

Referring to Figure 1, there is shown an electronic device 10 formed according to the present invention. A thin-film electronic component or device 12, such as a conductor, a thin-film transistor, a diode, or other component or device, is formed onto a flexible substrate 20 such as a metal foil. A layer 14 of silicon nitrite, for example, may be provided between component 12 and substrate 20 to provide a barrier against diffusion of impurities from substrate 20 into electronic device 10. During device fabrication, substrate 20 is provided on, deposited on, laminated to, or otherwise attached to a carrier 18 that provides dimensional stability for substrate 20 over the range of processing temperatures and conditions required for thin-film device manufacture. Various techniques for attaching substrate 20 to carrier 18 are disclosed in accordance with the present invention.

The apparatus and methods of the present invention provide ways to fabricate electronic device 10 on flexible substrate 20 using a carrier 18. Using the apparatus and methods of the present invention, a range of flexible substrates 20 can be used, supported on carrier 18 without requiring a match between the CTE of the substrate and that of the carrier. Thus, for example, a metal substrate such as stainless steel having a CTE of about 17 ppm/degree C could be supported on a glass carrier having a CTE in the range of 2 - 3 ppm/degree C. Unlike substrate mounting methods requiring closely matched CTE values, the present invention allows respective CTE values of the carrier 18 and substrate 20 to differ from each other by more than 2 ppm/degree C.

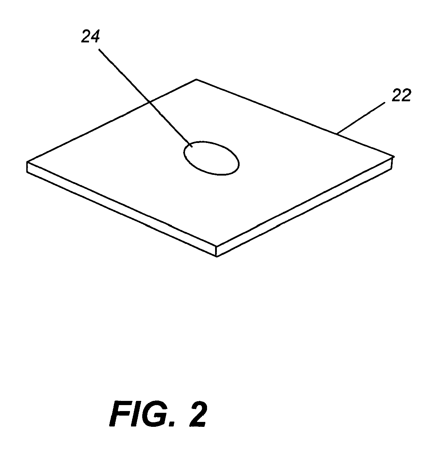

The perspective view of Figure 2 shows a carrier 22 that has been treated or conditioned for supporting a flexible substrate according to one embodiment. A holding area 24 on carrier 22 is formed by conditioning some portion of the surface of carrier 22, such as to effectively roughen the surface over this portion. Conditioning can be done using sandblasting or other abrasive treatment, corrosive etching, or using material deposition, for example. Holding area 24 may be a small portion of the carrier 22 surface, formed toward the center of this surface as shown in Figure 2, for reasons described in more detail subsequently.

Alternatively, such a holding area may be formed by conditioning the surface of carrier 22 around its perimeter, not illustrated, leaving an unconditioned central area opposite which an electronic device can be formed on a flexible substrate supported by the carrier. Also, a perimeter holding area may be formed on the contact surface of the flexible substrate by depositing adhesion-promoting material on the perimeter of the flexible substrate, thereby forming on the perimeter a stronger adhesive bond between the substrate and the carrier, than in the center. Or, an adhesion-reducing material may be applied in the central area of either the substrate, the carrier, or both, thereby also forming on the perimeter a stronger adhesive bond between the substrate and the carrier, than in the central area.

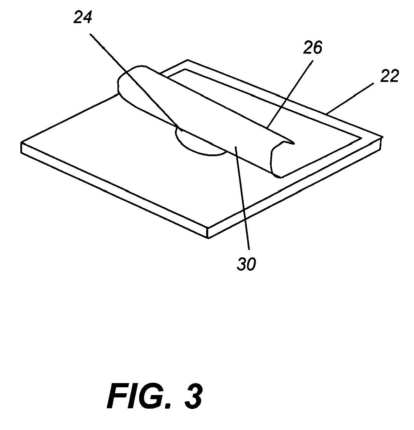

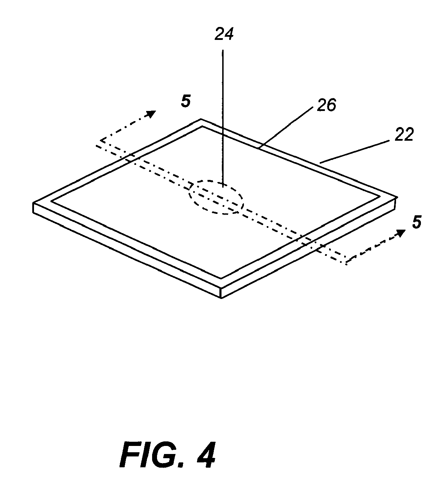

Figure 3 shows, in a partially completed state, a flexible substrate 26 being applied to carrier 22. A contact surface 30 of flexible substrate 26 is fitted or applied against holding area 24 formed on the conditioned surface of carrier 22 as shown in Figure 2. Alternatively, a holding area around the perimeter of carrier 22 may be provided as previously discussed. Figure 4 shows flexible substrate 26 fully applied against carrier 22, as flat to the surface of carrier 22 as possible, with entrapped gas between flexible substrate 26 and contact surface 30 of carrier 22 removed. In each configuration, at least a substantial portion of holding area 24 lies beneath substrate 26. Centering of substrate 26 over a central holding area 24 is advantageous for many applications, since this arrangement allows thermal expansion outward from a stable, fixed center area of substrate 26. However, there can be other applications for which substrate 26 is not centered about holding area 24. For example, holding area 24 may be disposed for retaining one or more edges of substrate 26, as in the described holding area around the perimeter of carrier 22.

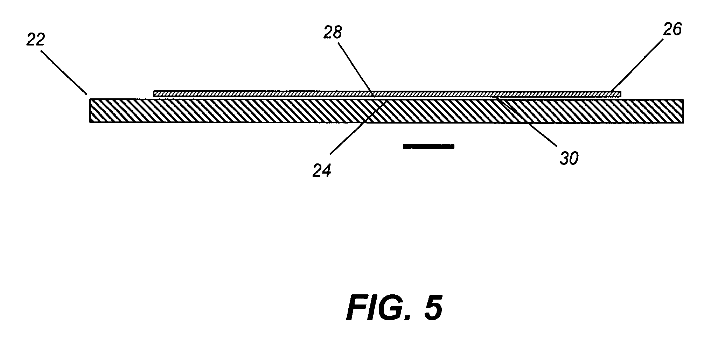

The cutaway side view of Figure 5 shows substrate 26 mounted on carrier 22. With holding area 24 near the center of substrate 26, thermal expansion or contraction of substrate 26 can occur without causing buckling or breakage of carrier 22. In order to provide a sufficient amount of grip or adhesion at the interface of the two surfaces, an intermediate binding material 28 of some type is applied to contact surface 30 at this interface, particularly at holding area 24. Binding material 28 may be an adhesive, such as epoxy, or may be some other material, or composite material, that temporarily fixes substrate in place on carrier 22, with enough adhesion so that at least a portion of substrate 26 does not exhibit any perceptible shift relative to carrier 22, in the plane of the contact interface, during processing. Binding material 28 may be a reflowable plastic binder taken from the group consisting of heat-stabilized polyethylene terephthalate (HS-PET), polyethylenenapthalate (PEN), polycarbonate (PC), polyarylate (PAR), polyetherimide (PEI), polyethersulphone (PES), polyimide (PI), Teflon poly(perfluoro-alboxy)fluoropolymer (PFA), Kapton, poly(ether ether ketone) (PEEK), poly(ether ketone) (PEK), poly(ethylene tetrafluoroethylene) fluoropolymer (PETFE), poly(methyl methacrylate), acrylate/methacrylate copolymers (PMMA), cyclic polyolefins, ethylene-chlorotrifluoro ethylene (E-CTFE), ethylene-tetra-fluoroethylene (E-TFE), poly-tetrafluoro-ethylene (PTFE), fiber glass enhanced plastic (FEP), and high density polyethylene (HDPE).

### Example

In one embodiment, binding material 28 is a reflowable plastic binder material such as a Teflon coating. Flexible substrate 26 is a sheet of grade 304 stainless steel. The following basic sequence is used.
1. Surface preparation. In this step, a thin Teflon (PTFE) coating is applied as binding material 28 to contact surface 30 of flexible substrate 26. This can be applied using any suitable deposition technique. A thickness of between about 0.0005 - 0.002 in. may be sufficient for a smaller substrate 26; this thickness can vary depending on the stiffness and area of substrate 26.
2. Positioning. Substrate 26 is positioned so that it is centered about holding area 24 on carrier 22.
3. Lamination. Lamination of substrate 26 to carrier 22 is performed by applying heat and pressure to achieve the flow temperature (Tg) of the PTFE binding material 28, approximately 300 degrees C. The PTFE material softens, reflows, and bonds that portion of substrate 26 that lies atop holding area 24. Entrapped gas between the carrier and contact surface 30 of the substrate is forced out as the heat and pressure are applied.
4. Processing. Substrate 26 is then processed to form one or more electronic devices 10 (Figure 1).
5. De-lamination. Heat is then used once again to cause a reflow of the PTFE material at approximately 300 degrees C. Substrate 26 can then be lifted away from the surface of carrier 22. If the holding area has been provided around the perimeter of the surface of carrier 22 or in a ring form on the contact surface of the substrate, the electronic device can be removed by cutting through substrate 26 inside the perimetral or ring form holding area to the unconditioned central area of the carrier, thus enabling the electronic device to be removed easily. The cutting may be done by laser, saw-cutting or chemical etching, for example.

The steps given for this example admit any of a number of variations. For example, the thickness as well as the composition of binding material 28 can be suitably adjusted for substrate 26 and carrier 22 conditions. A relatively pure Teflon material can be used; however, a composition that includes Teflon with particulate, fibrous, or other filler materials could alternately be used, where the particulate additive provides improved behavior, temperature range, or other condition.

Where carrier 22 is glass having an etched, sandblasted, or deposited holding area 24, a Teflon or other reflowable plastic material provides a relatively strong bond to the roughened glass holding area. Outside of holding area 24, the reflowable plastic material acts as a barrier to minimize entrapment of air or other gases between the interfacing surfaces of substrate 26 and carrier 22. Reheating the Teflon intermediate binding material then allows removal of substrate 26 from carrier 22. In some embodiments, intermediate binding material 28 remains deposited on substrate 26 after its removal from the carrier 22 surface, serving as a dielectric layer for the fabricated device or circuit, for example.

Heat and pressure provide one type of lamination. Other lamination methods may use heat alone, pressure alone, or solvents or other materials as intermediate binding material 28. Where epoxy or other adhesive is used, heat or electromagnetic energy can be applied to weaken the epoxy bond sufficiently for substrate 26 removal following component fabrication. For example, a number of types of epoxy lose adhesive strength under higher temperatures. For example, Epo-Tek 353ND epoxy, available from Epoxy Technology, Inc., Billerica, MA, and similar epoxies can have relatively low glass transition temperatures for extended periods of heat application and degradation temperatures at which bond strength significantly decreases.

De-lamination can be performed in a number of ways, using heat our chemicals for example. Alternately, peeling could be used for delamination, including methods that peel using a metal or metal wire skive, for example. Radiation over a band of wavelengths can be used to fix or soften intermediate binding material 28 between carrier 22 and substrate 26. Radiation wavelengths can be chosen so that either substrate 26 or carrier 22 is substantially transparent to the radiation energy.

The invention has been described in detail with particular reference to certain preferred embodiments thereof, but it will be understood that variations and modifications can be effected within the scope of the invention as described above, and as noted in the appended claims, by a person of ordinary skill in the art without departing from the scope of the invention. For example, holding area 24 can be formed on the surface of carrier 22 in a number of ways. Methods for conditioning this surface to form holding area 24 can include the use of abrasive materials, such as sandblasting, or chemicals such as etchants, for example. These methods tend to roughen the surface by removing material. Alternately, methods for deposition of material onto the surface of carrier 22 can also be used. Methods such as sputtering can be used to add an area of material that is the same as is already used in carrier 22; alternately, a different material can be deposited onto the surface of carrier 22 to form holding area 24. Particulate material could be embedded in the surface of carrier 22 to form holding area 24. Various materials could be bonded to the surface of carrier 22 to form holding area 24. Deposition methods can be particularly advantageous where it is desirable to apply pressure, without heat, for mounting substrate 26 to carrier 22. The invention also includes providing a conditioned retaining area on the contact or underside of substrate 26, rather than on the upper surface of carrier 22, as already described. For example, the contact surface of substrate 26 could be chemically treated to facilitate adhesion of the plastic binder material. The surfaces of carrier 22 or substrate 26 also may be chemically pre-treated to facilitate separation from binding material 28 during de-lamination.

Thus, what is provided is a method for mounting a substrate to a carrier for forming an electronic device on a flexible substrate.

### PARTS LIST

- 10.: electronic device
- 12.: thin-film electronic component or device
- 14.: layer
- 18.: carrier
- 20.: flexible substrate
- 22.: carrier
- 24.: holding area
- 26.: flexible substrate
- 28.: intermediate binding material
- 30.: contact surface

### SUMMARY OF THE INVENTION

1. A method for forming an electronic device on a flexible substrate comprising:
   conditioning the surface of a carrier to form a holding area for retaining a flexible substrate;
   applying a contact surface of the flexible substrate against the carrier with an intermediate binding material applied between at least the holding area of the carrier and the corresponding area of the contact surface;
   removing entrapped gas between the flexible substrate and the carrier;
   processing the substrate to form the electronic device thereon; and
   removing the flexible substrate from the holding area.
2. The method of 1 wherein the intermediate binding material is a reflowable plastic binder material.
3. The method of 2 wherein the plastic binder material is coated onto the contact surface of the substrate.
4. The method of 2 wherein the reflowable plastic binder is taken from the group consisting of heat-stabilized polyethylene terephthalate (HS-PET), polyethylenenapthalate (PEN), polycarbonate (PC), polyarylate (PAR), polyetherimide (PEI), polyethersulphone (PES), polyimide (PI), Teflon poly(perfluoro-alboxy)fluoropolymer (PFA), Kapton, poly(ether ether ketone) (PEEK), poly(ether ketone) (PEK), poly(ethylene tetrafluoroethylene)fluoropolymer (PETFE), poly(methyl methacrylate), acrylate/methacrylate copolymers (PMMA), cyclic polyolefins, ethylene-chlorotrifluoro ethylene (E-CTFE), ethylene-tetra-fluoroethylene (E-TFE), poly-tetrafluoro-ethylene (PTFE), fiber glass enhanced plastic (FEP), and high density polyethylene (HDPE).
5. The method of 1 wherein applying comprises laminating a portion of the contact surface of the flexible substrate to the holding area.
6. The method of 5 wherein laminating comprises irradiating the substrate and carrier to fix the intermediate binding material.
7. The method of 6 further comprising irradiating the substrate and carrier for removing the substrate.
8. The method of 1 wherein the carrier absorbs radiation over a band of wavelengths and the substrate is substantially transparent to said band of wavelengths.
9. The method of 1 wherein the flexible substrate is metal.
10. The method of 1 wherein the intermediate binding material is an epoxy.
11. The method of 1 wherein the respective coefficient of thermal expansion values of the carrier and the flexible substrate differ from each other by more than 2 ppm/degree C.
12. The method of 1 wherein conditioning the surface comprises sandblasting.
13. The method of 1 wherein conditioning the surface comprises corrosive etching.
14. The method of 1 wherein conditioning the surface comprises depositing a material on the surface.
15. A method for forming an electronic device on a flexible substrate comprising:
   conditioning an area on the surface of a carrier as a holding area for adhesion to a flexible substrate;
   coating at least a portion of a contact surface of the flexible substrate with a reflowable plastic binder material;
   applying the contact surface of the flexible substrate against the carrier and removing entrapped gas between the flexible substrate and the carrier;
   attaching at least the coated portion of the contact surface of the flexible substrate to the holding area;
   processing the substrate to form the electronic device thereon; and
   detaching the substrate material from the holding area.
16. The method of 15 wherein attaching is done by laminating and detaching is done by delaminating.
17. The method of 15 wherein the reflowable plastic binder material is poly-tetrafluoro-ethylene (PTFE).
18. The method of 15 wherein the reflowable plastic binder material is retained on the contact surface of the flexible substrate when the substrate is removed from the carrier.
19. The method of 15 further comprising the step of removing the reflowable plastic binder material from the contact surface of the flexible substrate.
20. The method of 15 wherein conditioning the area of the carrier comprises sandblasting a portion of the carrier surface.
21. The method of 15 wherein conditioning the area of the carrier comprises etching a portion of the carrier surface.
22. An electronic device formed in accordance with the method of 1.
23. An electronic device formed in accordance with the method of 15.
24. A method for forming an electronic device on a flexible substrate comprising:
   providing a flexible substrate;
   providing a carrier;
   conditioning a contact surface of the substrate to form a holding area for contacting the carrier;
   applying the contact surface of the flexible substrate against the carrier with an intermediate binding material applied between at least the holding area of the substrate and the corresponding area of the carrier;
   removing entrapped gas between the flexible substrate and the carrier;
   processing the substrate to form the electronic device thereon; and
   removing the flexible substrate from the holding area.
25. An electronic device formed in accordance with the method of 24.

## Claims

1. A method for forming an electronic device on a flexible substrate comprising:
conditioning the surface of a carrier to form a holding area for retaining a flexible substrate;
applying a contact surface of the flexible substrate against the carrier with an intermediate binding material applied between at least the holding area of the carrier and the corresponding area of the contact surface;
removing entrapped gas between the flexible substrate and the carrier;
processing the substrate to form the electronic device thereon; and
removing the flexible substrate from the holding area.

2. The method of claim 1 wherein the intermediate binding material is a reflowable plastic binder material.

3. The method of claim 2 wherein the plastic binder material is coated onto the contact surface of the substrate.

4. The method of claim 2 wherein the reflowable plastic binder is taken from the group consisting of heat-stabilized polyethylene terephthalate (HS-PET), polyethylenenapthalate (PEN), polycarbonate (PC), polyarylate (PAR), polyetherimide (PEI), polyethersulphone (PES), polyimide (PI), Teflon poly(perfluoro-alboxy)fluoropolymer (PFA), Kapton, poly(ether ether ketone) (PEEK), poly(ether ketone) (PEK), poly(ethylene tetrafluoroethylene)fluoropolymer (PETFE), poly(methyl methacrylate), acrylate/methacrylate copolymers (PMMA), cyclic polyolefins, ethylene-chlorotrifluoro ethylene (E-CTFE), ethylene-tetra-fluoroethylene (E-TFE), poly-tetrafluoro-ethylene (PTFE), fiber glass enhanced plastic (FEP), and high density polyethylene (HDPE).

5. The method of claim 1 wherein applying comprises laminating a portion of the contact surface of the flexible substrate to the holding area.

6. The method of claim 1 wherein the carrier absorbs radiation over a band of wavelengths and the substrate is substantially transparent to said band of wavelengths.

7. The method of claim 1 wherein the respective coefficient of thermal expansion values of the carrier and the flexible substrate differ from each other by more than 2 ppm/degree C.

8. A method for forming an electronic device on a flexible substrate comprising:
conditioning an area on the surface of a carrier as a holding area for adhesion to a flexible substrate;
coating at least a portion of a contact surface of the flexible substrate with a reflowable plastic binder material;
applying the contact surface of the flexible substrate against the carrier and removing entrapped gas between the flexible substrate and the carrier;
attaching at least the coated portion of the contact surface of the flexible substrate to the holding area;
processing the substrate to form the electronic device thereon; and
detaching the substrate material from the holding area.

9. The method of claim 15 wherein attaching is done by laminating and detaching is done by delaminating.

10. The method of claim 15 wherein the reflowable plastic binder material is poly-tetrafluoro-ethylene (PTFE).

11. The method of claim 15 wherein the reflowable plastic binder material is retained on the contact surface of the flexible substrate when the substrate is removed from the carrier.

12. The method of claim 15 further comprising the step of removing the reflowable plastic binder material from the contact surface of the flexible substrate.

13. The method of claim 15 wherein conditioning the area of the carrier comprises sandblasting a portion of the carrier surface.

14. The method of claim 15 wherein conditioning the area of the carrier comprises etching a portion of the carrier surface.

15. A method for forming an electronic device on a flexible substrate comprising:
providing a flexible substrate;
providing a carrier;
conditioning a contact surface of the substrate to form a holding area for contacting the carrier;
applying the contact surface of the flexible substrate against the carrier with an intermediate binding material applied between at least the holding area of the substrate and the corresponding area of the carrier;
removing entrapped gas between the flexible substrate and the carrier;
processing the substrate to form the electronic device thereon; and
removing the flexible substrate from the holding area.
